Europäisches Patentamt

European Patent Office

Office européen des brevets

(19)

(11) Veröffentlichungsnummer: **0 048 366**
A2

# (12) EUROPÄISCHE PATENTANMELDUNG

(21) Anmeldenummer: **81106923.6**

(22) Anmeldetag: **04.09.81**

(51) Int. Cl.³: **H 01 L 31/04**
**H 01 L 31/18**

(30) Priorität: **20.09.80 DE 3035563**

(43) Veröffentlichungstag der Anmeldung:
**31.03.82 Patentblatt 82/13**

(84) Benannte Vertragsstaaten:
**BE FR GB IT NL SE**

(71) Anmelder: **Licentia Patent-Verwaltungs-GmbH**
**Theodor-Stern-Kai 1**
**D-6000 Frankfurt/Main 70(DE)**

(72) Erfinder: **Dahlberg, Reinhard, Dr.**
**Innere Bergstrasse 32**
**D-7101 Flein(DE)**

(74) Vertreter: **Langer, Karl-Heinz, Dipl.-Ing. et al,**
**Licentia Patent-Verwaltungs-GmbH Theodor-Stern-Kai**
**1**
**D-6000 Frankfurt/Main 70(DE)**

(54) **Silizium-Schicht-Solarzelle.**

(57) Die Anmeldung betrifft eine Silizium-Schicht-Solarzelle,
bei welcher die aktive Silizium-Schicht der Solarzelle auf ein
niederohmiges Silizium-Substrat aufgebracht ist. Die Erfindung besteht darin, daß mindestens das Silizium-Substrat
auf pulvermetallurgischem Wege hergestellt ist.

FIG.2

Licentia Patent-Verwaltungs-G.m.b.H.
Theodor-Stern-Kai 1, 6000 Frankfurt 70


Heilbronn, den 12.09.1980
SE2-HN-La-pi - HN 80/44


Silizium-Schicht-Solarzelle


Silizium-Solarzellen zur Umwandlung von Sonnen-Energie in Elektrizität erlangen technisch eine immer größere Bedeutung. Jede weitere Senkung der Herstellkosten wird den Anwendungsbereich der Silizium-Solarzellen weiter vergrößern.

Ein entscheidender Schritt zur Verbilligung der Herstellkosten ist die polykristalline Silizium-Solarzelle. Bei der polykristallinen Silizium-Solarzelle können die Kosten für das Silizium-Ausgangsmaterial wesentlich reduziert werden. Da für die elektrische Funktion der Silizium-Solarzelle eine nur etwa 100 micron dicke polykristaline Silizium-Schicht benötigt wird, ist es möglich, diese etwa 100 micron dicke Silizium-Schicht auf ein geeignetes Substrat aufzubringen und auf diese Weise eine Silizium-Solarzelle in an sich bekannter Weise herzustellen. Versuche mit Silizium-Schichten auf Edelstahl sind aus "Material Eng. October 1979, S. 6" und Versuche über Silizium-Schichten auf Kohle sind aus "VDI-Nachrichten, 22.08.1980, S. 6" bekannt. Es ist auch möglich, Substrate aus sehr niederohmigem (metallurgischhergestelltem) Silizium zu verwenden. Leider hat das metallurgische Silizium als Substrat-Material zwei Nachteile: es läßt sich nur mit wesentlich höherem Aufwand (als z. B. Kohle oder Metalle) zu Substraten formen und es enthält normalerweise Lunker (Hohlräume), die sehr störend sind.

Der Erfindung liegt die Aufgabe zugrunde, eine Silizium-Solarzelle anzugeben, die die Nachteile bekannter polykristalliner Silizium-Schicht-Solarzellen nicht aufweist. Diese
Aufgabe wird durch eine Silizium-Schicht-Solarzelle, bei
der die aktive Schicht auf ein niederohmiges Silizium-Substrat aufgebracht ist, nach der Erfindung dadurch gelöst,
daß mindestens das Silizium-Substrat auf pulvermetallurgischem Wege hergestellt ist.

Dabei wird Silizium-Pulver zu einem geeigenten Preßkörper
geformt, der bei einer hinreichend hohen Temperatur gesintert
oder geschmolzen ist. Das Sintern oder Schmelzen des Pulver-
Preßkörpers kann in einem Ofen mit Intergas-Atmosphäre oder
in einem Vakuum-Ofen erfolgen. Das Sintern oder Schmelzen
des Pulver-Preßkörpers kann aber auch erfindungsgemäß mit
Hilfe eines elektrischen Stromes durch den Pulver-Preßkörper
herbeigeführt werden. Hierbei sorgt die Joul'sche Wärme
für das Erreichen der benötigten Temperatur. Da Silizium
am Schmelzpunkt eine geringe Viskosität hat, ist es vorteilhaft, das Sintern oder Schmelzen des Pulver-Preßkörpers
mit Hilfe eines kurzzeitigen elektrischen Stoßstromes
durchzuführen, bei dem durch die Joul'sche Wärme in kurzer
Zeit die benötigte Temperatur erzeugt wird. Zur Erzeugung
eines sehr gleichmäßigen Sinterprozesses kann das Sintern
oder Schmelzen des Pulver-Preßkörpers auch erfindungsgemäß
unter gleichzeitigem mechanischem Druck erfolgen. Zum
Sintern oder Schmelzen des Pulver-Preßkörpers eignet sich
auch besonders eine sehr intensive Elektronen-Bestrahlung
oder eine Bestrahlung mit elektromagnetischer Strahlung,
wie z. B. fokussiertem Licht oder Laser-Strahlung.

Der Silizium-Pulver-Preßkörper kann durch mechanisches Zusammenpressen vorn geeignetem Silizium-Pulver unter hinreichend hohem Druck ohne jedes Bindemittel erfolgen. Er
kann aber auch mit Hilfe einer Flüssikeit oder eines
schmelzbaren Bindemittels aus Silizium-Pulver geformt
werden. Für die Massenproduktion von Pulver-Preßkörpern
nach diesem Verfahren eignet sich besonders die Verwendung
einer Extrusions-Press. Das Silizium für den Silizium-Pulver-
Preßling des Substrates ist vorzugsweise metallurgisches
Silizium, das mit einer Reinheit von 98 - 99 % zu Preisen zwischen 2500 und 3000 DM pro Tonne käuflich ist. Das Silizium für den Pulver-Preßling des Substrates kann jedoch auch Verunreinigungen von Aluminium oder Eisen bis zu 30 Gewichtsprozenten enthalten. Dadurch wird ein Sinterkörper herstellbar, dessen Schmelztemperatur etwas niedriger liegt als die Schmelztemperatur des technischen Siliziums.

Die aktive Silizium-Schicht zur Herstellung der eigentlichen Solarzelle kann auf das gesinterte oder geschmolzene Silizium-Subatrat durch chemisches Abscheiden von reinem Silizium aus der Gasphase aufgebracht werden. Dazu können an sich bekannte Verfahren der Epitaxie und der pyrolytischen Abscheidung aus der Gasphase verwendet werden. Es ist jedoch erfindungsgemäß auch möglich, einen Tropfen flüssigen reinen Siliziums auf das Siliziums-Substrat aufzubringen, während das Substrat mit hinreichend hoher Geschwindigkeit um eine Achse senkrecht zu seiner Oberfläche rotiert. Durch diese Rotation wird das flüssige Silizium durch die Fliehkräfte gleichmäßig über die Substrat-Oberfläche verteilt bevor es erstarrt. Die aktive Silizium-Schicht kann jedoch auch in an sich bekannter Weise durch Aufdampfen im Hochvakuum durch Plasma-Zerstäuben oder durch Plasma-Spritzen aufgebracht werden. Es ist auch möglich, die Silizium-Schicht zunächst in Pulverform auf das Substrat aufzubringen und danach aufzuschmelzen. Die Silizium-Schicht kann jedoch auch zusammen mit dem Substrat-Silizium als Pulver-Preßkörper hergestellt sein, welcher durch kurzzeitiges Erhitzen gesintert oder aufgeschmolzen wird. Die aktive Silizium-Schicht auf dem Substrat kann mit Hilfe eines Diffusionsprozesses, mit Hilfe von Ionenimplantation oder durch Überschichten mit dünnen Metall- oder Halbleiterschichten sowie mit Hilfe nachfolgender Kontaktierungsvorgänge in eine Solarzelle verwandelt werden.

Im folgenden wird die Erfindung an Hand von Ausführungsbeispielen näher erläutert.

Fig. 1 zeigt einen Silizium-Pulver-Preßkörper - 1a - und ein gesintertes bzw. geschmolzenes Substrat - 1b-.

Fig. 2 beschreibt das Sintern oder Schmelzen eines Silizium-Pulver-Preßlings mit Hilfe eines Kondensator-Stoßstromes.

Fig. 3 zeigt schematisch das Aufschleudern einer Silizium-Schicht auf ein rotierendes Silizium-Substrat.

Fig. 4 beschreibt das gleichzeitige Aufschmelzen eines Pulver-Preßkörpers durch das Substrat und einer Pulver-schicht durch die aktive Silizium-Schicht.

Fig. 5 beschreibt das Aufschmelzen einer Silizium-Pulver-Schicht auf einem bewegten Silizium-Substrat mit Hilfe von fokussiertem Licht.

Ausführungsbeispiel 1

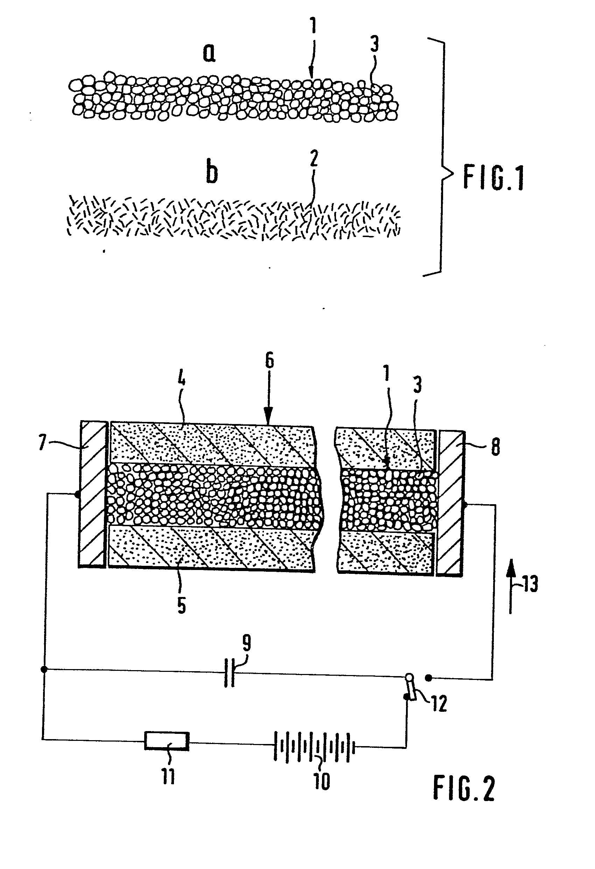

Fig. 1a zeigt einen Silizium-Pulver-Preßkörper 1, der durch Zusammenpressen von Silizium-Pulverkörnern 3 erzeugt ist.

Fig. 1b zeigt im Querschnitt das Silizium-Substrat 2, welches durch Sintern oder Aufschmelzen des Silizium-Pulver-Preßkörpers 1 entstanden ist.

Ausführungsbeispiel 2

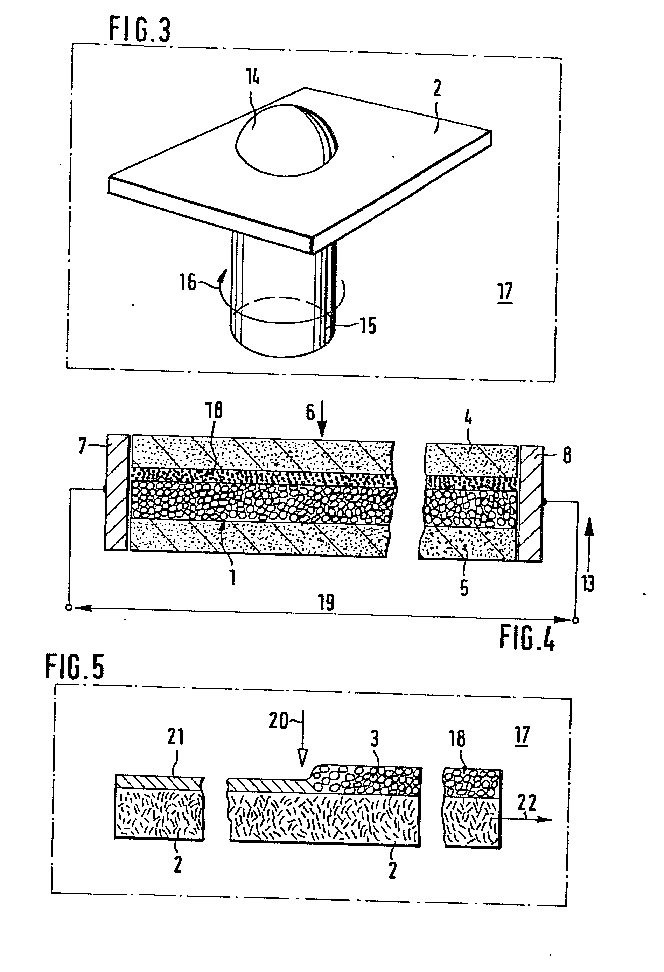

In Fig. 2 bedeutet 1 einen Silizium-Pulver-Preßling, welcher zwischen einem Keramik-Druck-Stempel 4 und einer Keramik-Bodenplatte 5 unter einem hohen Druck 6 gehalten ist. 7 und 8 sind elektrisch leitende Druck-Kontakte, über welche der elektrische Stoßstrom 13 aus dem Kondensator 9 über den Silizium-Pulver-Preßling 3 fließt. Der Kondensator 9 wird über den elektrischen Ladewiderstand 11 und den Schalter 12 aus der Gleichstrombatterie 10 aufgeladen.

## Ausführungsbeispiel 3

In Fig. 3 rotiert das Silizium-Substrat 2 um die Achse 15 mit der Geschwindigkeit 16. In der Mitte des rotierenden Substrats 2 befindet sich der flüssige Silizium-Tropfen 14, welcher durch die Zentrifugalkraft der Rotation gleichmäßig über die Oberfläche des Substrates 2 verteilt wird. Die Anordnung befindet sich in einem sauerstoffreien Raum 17.

## Ausführungsbeispiel 4

Der Silizium-Pulver-Preßling 1 mit der Silizium-Pulver-Schicht 18 befindet sich unter dem Druck 6 zwischen dem Keramik-Druck-Stempel 4 und der Keramik-Bodenplatte 5. Übre die elektrisch leitenden Druck-Stempel 7 und 8 fließt der elektrische Stoßstrom 13 aus der Stoßstrom-Quelle 19 über den Silizium-Preßkörper 1. Der Silizium-Preßkörper 1 wird sehr kurzzeitig bis über seine Schmelztemperatur erhitzt, wodurch auch die Pulver-Schicht 18 aufschmilzt. Das Erstarren des Silizium-Körpers erfolgt unter dem Druck 6.

## Ausführungsbeispiel 5

In Fig. 5 führt das Silizium-Substrat 2, welches mit der Silizium-Pulver-Schicht 18 einseitig beschichtet ist, die Bewegung 22 aus. Über einen fokussierten Lichtstrahl 20 wird das Silizzium im Bestrahlungsbereich aufgeschmolzen, so daß die Pulver-Schicht 18 mit den Pulverkörnern 3 in die Silizium-Schicht 21 umgewandelt wird. Die Anordnung befindet sich in einem Raum 17 mit Inertgas oder im Vakukum.

Licentia Patent-Verwaltungs-G.m.b.H.
Theodor-Stern-Kai 1, 6000 Frankfurt 70

Heilbronn, den 11.09.1980
SE2-HN-La-pi   HN 80/44

Patentansprüche

1) Silizium-Schicht-Solarzelle, bei welcher die aktive Silizium-Schicht der Solarzelle auf ein niederohmiges Silizium-Substrat aufgebracht ist, dadurch gekennzeichnet, daß mindestens das Silizium-Substrat auf pulvermetallurgischem Wege hergestellt ist.

2) Silizium-Schicht-Solarzelle nach Anspruch 1, dadurch gekennzeichnet, daß das Silizium-Substrat in Form eines Silizium-Pulver-Preßkörpers bei hinreichend hoher Temperatur gesintert oder geschmolzen ist.

3) Silizium-Schicht-Solarzelle nach einem der vorhergehenden Ansprüche, dadurch gekennzeichnet, daß das Sintern oder Schmelzen des Pulver-Preßkörpers in einem Inertgas-Ofen oder in einem Vakuum-Ofen erfolgt.

4) Silizium-Schicht-Solarzelle nach einem der vorhergehenden Ansprüche, dadurch gekennzeichnet, daß das Sintern oder Schmelzen des Pulver-Preßkörpers mit Hilfe eines elektrischen Stromes durch den Pulver-Preßkörper erfolgt.

5) Silizium-Schicht-Solarzelle nach einem der vorhergehenden Ansprüche, dadurch gekennzeichnet, daß das Sintern oder Schmelzen des Pulver-Preßkörpers mit Hilfe eines kurzzeitigen elektrischen Stoßstromes durch den Pulver-Preßkörper erfolgt.

6) Silizium-Schicht-Solarzelle nach einem der vorhergehenden Ansprüche, dadurch gekennzeichnet, daß das Sintern oder Schmelzen des Pulver-Preßkörpers unter gleichzeitig mechanischem Druck erfolgt.

7) Silizium-Schicht-Solarzelle nach einem der vorhergehenden Ansprüche, dadurch gekennzeichnet, daß das Sintern oder Schmelzen des Pulver-Preßkörpers durch intensive Bestrahlung mit Elektronen- oder elektromagnetischer Strahlung erfolgt.

8) Silizium-Schicht-Solarzelle nach einem der vorhergehenden Ansprüche, dadurch gekennzeichnet, daß der Pulver-Preßkördurch mechanisches Zusammenpressen von Silizium-Pulver erzeugt ist.

9) Silizium-Schicht-Solarzelle nach einem der vorhergehenden Ansprüche, dadurch gekennzeichnet, daß der Pulver-Preßkörper aus Siliziumpulver mit Hilfe einer Flüssigkeit oder eines schmelzbaren Bindemittels geformt ist.

10) Silizium-Schicht-Solarzelle nach einem der vorhergehenden Ansprüche, dadurch gekennzeichnet, daß der Pulver-Preßkörper mit Hilfe eines Extrusions-Verfahrens hergestellt ist.

11) Silizium-Schicht-Solarzelle nach einem der vorhergehenden Ansprüche, dadurch gekennzeichnet, daß Silizium-Pulver aus metallugischem Silizium verwendet ist.

12) Silizium-Schicht-Solarzelle nach einem der vorhergehenden Ansprüche, dadurch gekennzeichnet, daß das Silizium- Pulver bis zu 30 Gewichtprozenten Aluminium oder Eisen enthält.

13) Silizium-Schicht-Solrzelle nach einem der vorhergehenden Ansprüche, dadurch gekennzeichnet, daß die Silizium- Schicht auf das Substrat durch chemisches Abscheiden aus der Gasphase aufgebracht ist.

14) Silizium-Schicht-Solarzelle nach einem der vorhergehenden Ansprüche, dadurch gekennzeichnet, daß die Silizium-Schicht auf das Substrat durch Aufschleudern von flüssigem Silizium aufgebracht ist.

15) Silizium-Schicht-Solarzelle nach einem der vorhergehenden Ansprüche, dadurch gekennzeichnet, daß die Silizium-Schicht auf das Substrat durch Aufdampfen oder durch Plasma-Spritzen aufgebracht ist.

16) Silizium-Schicht-Solarzelle nach einem der vorhergehenden Ansprüche, dadurch gekennzeichnet, daß die Siliziumschicht auf das Substrat in Pulverform aufgebracht und danach aufgeschmolzen ist.

17) Silizium-Schicht-Solarzelle nach einem der vorhergehenden Ansprüche, dadurch gekennzeichnet, daß die Silizium-Schicht zusammen mit dem Substrat als Pulver-Preßkörper hergestellt ist, und daß dieser Preßkörper durch kurzzeitiges Erhitzen gesintert oder aufgeschmolzen ist.

0048366

FIG.1

FIG.2

FIG.3

FIG.4

FIG.5